(19) Europäisches Patentamt
European Patent Office
Office européen des brevets

(11) **EP 2 398 934 B1**

(12) **EUROPÄISCHE PATENTSCHRIFT**

(45) Veröffentlichungstag und Bekanntmachung des Hinweises auf die Patenterteilung:
**21.06.2017  Patentblatt 2017/25**

(21) Anmeldenummer: **10703058.7**

(22) Anmeldetag: **05.02.2010**

(51) Int Cl.:
*C23C 18/12* *(2006.01)*

(86) Internationale Anmeldenummer:
**PCT/EP2010/051432**

(87) Internationale Veröffentlichungsnummer:
**WO 2010/094583 (26.08.2010 Gazette 2010/34)**

(54) **VERFAHREN ZUR HERSTELLUNG HALBLEITENDER INDIUMOXID-SCHICHTEN, NACH DEM VERFAHREN HERGESTELLTE INDIUMOXID-SCHICHTEN UND DEREN VERWENDUNG**

PROCESS FOR PREPARING SEMICONDUCTING INDIUM OXIDE LAYERS, OBTAINABLE ARTICLES AND USE OF SUCH LAYERS

PROCEDE POUR LA FABRICATION DES CUOCHES D'OXYDE D'INDIUM SEMICONDUCTEURS, ARTICLES OBTENUES ET UTILISATION DE CETTES COUCHES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **17.02.2009   DE 102009009337**

(43) Veröffentlichungstag der Anmeldung:
**28.12.2011   Patentblatt 2011/52**

(73) Patentinhaber: **Evonik Degussa GmbH**
**45128 Essen (DE)**

(72) Erfinder:
• **HOPPE, Arne**
**44623 Herne (DE)**

• **MERKULOV, Alexey**
**67059 Ludwigshafen (DE)**
• **STEIGER, Jürgen**
**40237 Düsseldorf (DE)**
• **PHAM, Duy Vu**
**46049 Oberhausen (DE)**
• **DAMASCHEK, Yvonne**
**45657 Recklinghausen (DE)**
• **THIEM, Heiko**
**64625 Bensheim (DE)**

(56) Entgegenhaltungen:
**WO-A1-2008/113632     JP-A- 2007 042 689**

**Beschreibung**

Die vorliegende Erfindung betrifft Verfahren zur Herstellung halbleitender Indiumoxid-Schichten, über die erfindungsgemäßen Verfahren herstellbare Indiumoxid- Schichten sowie deren Verwendung.

Die Herstellung halbleitender elektronischer Bauteilschichten über Druckprozesse ermöglicht im Vergleich zu vielen anderen Verfahren, wie z.B. Chemical Vapor Deposition (CVD) weitaus niedrigere Produktionskosten, da die Deposition des Halbleiters hier in einem kontinuierlichen Druckprozess erfolgen kann. Darüber hinaus eröffnet sich bei niedrigen Prozesstemperaturen die Möglichkeit, auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 $cm^2$/Vs bei einem Bauteil mit einer Kanallänge von 20 $\mu m$ und einer Kanalbreite von 1 cm bei 50 V Gate-Source-Spannung und 50 V Source-Drain-Spannung aufweisen.

Da das Material der über Druckverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, $In_2O_3$) ist aufgrund der großen Bandlücke zwischen 3.6 und 3.75 eV (gemessen für aufgedampfte Schichten) [H.S. Kim, P.D. Byrne, A. Facchetti, T.J. Marks; J. Am. Chem. Soc. 2008, 130, 12580-12581 ein vielversprechender Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 $cm^2$/Vs messen. Bislang können jedoch solche Werte durch Prozessierung aus Lösung noch nicht erreicht werden [H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513].

Indiumoxid wird oft vor allem zusammen mit Zinn(IV)-oxid ($SnO_2$) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxid-haltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches Vorprodukt nach dem Verdrucken zu einer Indiumoxid-haltigen Schicht umgesetzt wird. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-Schichten. So können neben Indiumsalzen z.B. auch Indium-Alkoxide als Precursoren für die Herstellung von Indiumoxid-haltigen Schichten eingesetzt werden.

Zum Beispiel beschreiben Marks et al. Bauteile, bei deren Herstellung eine Precursorlösung aus $InCl_3$ sowie der Base Monoethanolamin (MEA) gelöst in Methoxyethanol eingesetzt wird. Nach Aufschleudern (Spin-coating) der Lösung wird die entsprechende Indiumoxid-Schicht durch eine thermische Behandlung bei 400 °C erzeugt. [H.S. Kim, P.D. Byrne, A. Facchetti, T.J. Marks; J. Am. Chem. Soc. 2008, 130, 12580-12581 and supplemental informations]

Gegenüber Indiumsalz-Lösungen bieten Indium-Alkoxid-Lösungen den Vorteil, dass sie bei geringeren Temperaturen zu Indiumoxid-haltigen Beschichtungen umgewandelt werden können.

Indium-Alkoxide und ihre Synthese sind bereits seit den siebziger Jahren des vorigen Jahrhunderts beschrieben. Mehrotra et al. beschreiben die Herstellung von Indium-tris-Alkoxid $In(OR)_3$ aus Indium(III)chlorid ($InCl_3$) mit Na-OR, wobei R für-Methyl, -Ethyl, iso-Propyl, n-, s-, t-Butyl und -Pentyl Reste steht. [S. Chatterjee, S. R. Bindal, R.C. Mehrotra; J. Indian Chem. Soc. 1976, 53, 867].

Bradley et al. berichten von einer ähnlichen Reaktion wie Mehrotra et al. und erhalten bei annähernd identischen Edukten ($InCl_3$, Isopropyl-Natrium) und Reaktionsbedingungen einen Indium-Oxo-Cluster mit Sauerstoff als Zentralatom [D.C. Bradley, H. Chudzynska, D.M. Frigo, M.E. Hammond, M.B. Hursthouse, M.A. Mazid; Polyhedron 1990, 9, 719].

Hoffman et al. zeigen eine alternative Syntheseroute zu Indium-Isopropoxid und erhalten im Gegensatz zu Mehrotra et al. einen unlöslichen weißen Feststoff. Sie vermuten einen polymeren Stoff [In(O-iPr)$_3$]$_n$[S. Suh, D. M. Hoffman; J. Am. Chem. Soc. 2000, 122, 9396-9404].

Viele Verfahren zur Herstellung von Indiumoxid-haltigen Beschichtungen über Precursorverfahren beruhen auf Sol-Gel-Techniken, bei denen aus Precursoren herstellbare Metallat-Gele durch einen Konvertierungsschritt in die entsprechenden Oxid-Schichten umgewandelt werden.

So beschreibt JP 11-106934 A (Fuji Photo Film Co. Ltd.) ein Verfahren zur Herstellung eines transparenten leitfähigen Metall-Oxid-Filmes auf einem transparenten Substrat über einen Sol-Gel-Prozess, bei dem unterhalb von 0 °C ein Metallalkoxid oder ein Metallsalz, bevorzugt ein Indiumalkoxid oder Indiumsalz, in Lösung hydrolysiert wird und dann das Hydrolysat erhitzt wird.

JP 06-136162 A (Fujimori Kogyo K.K.) beschreibt ein Verfahren zur Herstellung eines Metalloxid-Filmes aus Lösung auf einem Substrat, bei dem eine Metall-Alkoxid-Lösung, insbesondere eine Indium-Isopropoxid-Lösung, zu einem Metall-Oxid-Gel umgesetzt, auf ein Substrat aufgetragen, getrocknet und mit Wärme behandelt wird, wobei vor, während oder nach dem Trocknungs- und Wärmebehandlungsschritt mit UV-Strahlung bestrahlt wird.

Auch JP 09-157855 A (Kansai Shin Gijutsu Kenkyusho K.K.) beschreibt die Herstellung von Metalloxid-Filmen aus Metall-Alkoxid-Lösungen über eine Metall-Oxid-Sol-Zwischenstufe, die auf das Substrat aufgebracht und durch UV Strahlung in das jeweilige Metalloxid umgewandelt werden. Bei dem resultierenden Metalloxid kann es sich um Indiumoxid handeln.

CN 1280960 A beschreibt die Herstellung einer Indium-Zinn-Oxid-Schicht aus Lösung über ein Sol-Gel-Verfahren, bei dem ein Gemisch von Metall-Alkoxiden in einem Lösemittel gelöst, hydrolysiert und dann zur Beschichtung eines Substrates mit nachfolgender Trocknung und Härtung eingesetzt wird.

Die Sol-Gel-Verfahren haben jedoch gemein, dass ihre Gele entweder aufgrund der hohen Viskosität nicht für den Einsatz bei Druckprozessen geeignet sind und/oder, insbesondere im Falle gering konzentrierter Lösungen, die resultierenden Indiumoxid-haltigen Schichten Inhomogenitäten und somit schlechte Schicht-Parameter aufweisen. Unter einer Inhomogenität wird im vorliegenden Fall eine Kristallbildung in einzelnen Domänen verstanden, die an der Oberfläche zu Rauhigkeiten von über Rms = 5 nm (quadratische Rauheit; englisch *rms-roughness* = *root-mean-squared roughness*: Wurzel des Mittelquadrates; gemessen über Atomic Force Microscopy) führt. Diese Rauhigkeit wirkt sich zum einen nachteilig auf die Schichteigenschaften der Indiumoxid-haltigen Schicht (es resultieren vor allem zu geringe Ladungsträgerbeweglichkeiten für Halbleiter-Anwendungen) und zum anderen nachteilig für das Aufbringen weiterer Schichten zur Erzeugung eines Bauteils aus.

Im Gegensatz zu den bisher beschriebenen Sol-Gel-Techniken wird in JP 11-106935 A (Fuji Photo Film Co. Ltd.) ein Verfahren zur Herstellung eines leitfähigen Metall-Oxid-Filmes auf einem transparenten Substrat beschrieben, bei dem zur Erzielung von Härtungstemperaturen unterhalb von 250 °C, bevorzugt unterhalb von 100 °C, eine Beschichtungszusammensetzung enthaltend ein Metall-Alkoxid und/oder ein Metallsalz auf einem transparenten Substrat thermisch getrocknet und anschließend mit UV- oder VIS-Strahlung konvertiert wird.

Die bei diesem Verfahren eingesetzte Konvertierung über elektromagnetische Strahlung hat jedoch den Nachteil, dass die resultierende Schicht an der Oberfläche wellig und uneben ist. Dieses resultiert aus der Schwierigkeit, eine gleichmäßige und gleichförmige Strahlungsverteilung auf dem Substrat zu erreichen.

JP 2007-042689 A beschreibt Metallalkoxid-Lösungen, die zwingend Zinkalkoxide enthalten und weiterhin Indiumalkoxide enthalten können, sowie Verfahren zur Herstellung von Halbleiterbauelementen, die diese Metallalkoxid-Lösungen einsetzen. Die Metallalkoxid-Filme werden thermisch behandelt und zur Oxid-Schicht umgewandelt.

Reine Indiumoxid-Filme können jedoch mit den in JP 2007-042689 A beschriebenen Metall-Alkoxid-Lösungen und Verfahren nicht hergestellt werden. Darüber hinaus neigen im Gegensatz zu Indiumoxid-Zinnoxid-Schichten reine Indiumoxid-Schichten zu der bereits erwähnten (Teil-)Kristallisation, die zu einer verminderten Ladungsträgerbeweglichkeit führt.

Der vorliegenden Erfindung liegt somit die Aufgabe zugrunde, gegenüber dem bekannten Stand der Technik ein Verfahren zur Herstellung von Indiumoxid-Schichten bereitzustellen, das die Nachteile des dargelegten Standes der Technik vermeidet, und insbesondere bei noch verhältnismäßig geringen Temperaturen halbleitende, transparente Indiumoxid-Schichten mit hoher Homogenität und geringer Rauhigkeit (insbesondere eine Rauhigkeit ≤ 5 nm Rms) erzeugt und das bei Druckprozessen einsetzbar ist.

Diese Aufgaben werden gelöst durch ein Verfahren zur Herstellung halbleitender Indiumoxid-Schichten, bei dem ein Substrat mit einer flüssigen, wasserfreien Zusammensetzung umfassend a) mindestens ein Indium-Alkoxid und b) mindestens ein Lösemittel beschichtet, optional getrocknet, und bei Temperaturen größer 250 °C thermisch behandelt wird.

Unter einer Indiumoxid-Schicht im Sinne der vorliegenden Erfindung ist dabei eine aus den erwähnten Indiumalkoxiden herstellbare, metallhaltige Schicht zu verstehen, die im Wesentlichen Indiumatome bzw. -ionen aufweist, wobei die Indiumatome bzw. -ionen im Wesentlichen oxidisch vorliegen. Gegebenenfalls kann die Indiumoxid-Schicht auch noch Carben- bzw. Alkoxid-Anteile aus einer nicht vollständigen Konvertierung aufweisen.

Diese erfindungsgemäß herstellbaren halbleitenden Indiumoxid-Schichten weisen Ladungsträgerbeweglichkeiten zwischen 1 und 50 cm$^2$/Vs (gemessen bei 50 V Gate-Source-Spannung, 50 V Drain-Source-Spannung, 1 cm Kanalbreite und 20 $\mu$m Kanallänge) auf, wobei diese über das Modell der "Gradual Channel Approximation" bestimmt werden können. Hierzu werden die von klassischen MOSFETs bekannten Formeln verwendet. Im linearen Bereich gilt:

$$I_D = \frac{W}{L} C_i \mu \left( U_{GS} - U_T - \frac{U_{DS}}{2} \right) U_{DS} \tag{1}$$

wobei $I_D$ der Drain-Strom, $U_{Ds}$ die Drain-Source-Spannung, $U_{GS}$ die Gate-Source-Spannung, C; die flächennormierte Kapazität des Isolators, W die Breite des Transistorkanals, $L$ die Kanallänge des Transistors, $\mu$ die Ladungsträgerbeweglichkeit und $U_T$ die Schwellenspannung sind.

Im Sättigungsbereich gilt eine quadratische Abhängigkeit zwischen Drain-Strom und Gate-Spannung, die vorliegend zur Bestimmung der Ladungsträgerbeweglichkeit verwendet wird:

$$I_D = \frac{W}{2L} C_i \mu (U_{GS} - U_T)^2 \tag{2}$$

Unter flüssigen Zusammensetzungen im Sinne der vorliegenden Erfindung sind solche zu verstehen, die bei SATP-Bedingungen ("Standard Ambient Temperature and Pressure"; T = 25 °C und p = 1013 hPa) flüssig vorliegen. Wasserfreie Zusammensetzungen im Sinne der vorliegenden Erfindung sind solche, die weniger als 200 ppm $H_2O$ aufweisen. Entsprechende Trocknungsschritte, die zur Einstellung entsprechend niedriger Wassergehalte der Lösemittel führen, sind dem Fachmann bekannt.

Das Indium-Alkoxid ist bevorzugt ein Indium(III)-alkoxid. Weiter bevorzugt handelt es sich bei dem Indium(III)-alkoxid um ein Alkoxid mit mindestens einer C1- bis C15-Alkoxy- oder -Oxyalkylalkoxygruppe, besonders bevorzugt mindestens einer C1- bis C10-Alkoxy- oder -Oxyalkylalkoxy-gruppe. Ganz besonders bevorzugt ist das Indium(III)-Alkoxid ein Alkoxid der generischen Formel In(OR)$_3$, in der R eine C1- bis C15-Alkyl- oder -Alkyloxyalkylgruppe, noch weiter bevorzugt eine C1- bis C10-Alkyl-oder -Alkyloxyalkylgruppe darstellt. Besonders bevorzugt ist dieses Indium(III)-Alkoxid In(OCH$_3$)$_3$, In(OCH$_2$CH$_3$)$_3$, In(OCH$_2$CH$_2$OCH$_3$)$_3$, In(OCH(CH$_3$)$_2$)$_3$ oder In(OC(CH$_3$)$_3$)$_3$. Noch weiter bevorzugt wird In(OCH(CH$_3$)$_2$)$_3$ (Indiumisopropoxid) eingesetzt.

Das Indium-Alkoxid liegt bevorzugt in Anteilen von 1 bis 15 Gew.-%, besonders bevorzugt 2 bis 10 Gew.-%, ganz besonders bevorzugt 2,5 bis 7,5 Gew.-% bezogen auf die Gesamtmasse der Zusammensetzung vor.

Die Formulierung enthält weiterhin mindestens ein Lösemittel, d.h. die Formulierung kann sowohl ein Lösemittel oder ein Gemisch verschiedener Lösemittel enthalten. Vorzugsweise in der erfindungsgemäßen Formulierung einsetzbar sind aprotische und schwach protische Lösemittel, d.h. solche ausgewählt aus der Gruppe der aprotischen unpolaren Lösemittel, d.h. der Alkane, substituierten Alkane, Alkene, Alkine, Aromaten ohne oder mit aliphatischen oder aromatischen Substituenten, halogenierten Kohlenwasserstoffe, Tetramethylsilan, der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat und der schwach protischen Lösemittel, d.h. der Alkohole, der primären und sekundären Amine und Formamid. Besonders bevorzugt einsetzbare Lösemittel sind Alkohole sowie Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether. Ganz besonders bevorzugte Lösemittel sind Isopropanol, Tetrahydrofurfurylalkohol, tert-Butanol und Toluol sowie ihre Gemische.

Bevorzugt weist die bei dem erfindungsgemäßen Verfahren eingesetzte Zusammensetzung zur Erzielung einer besonders guten Verdruckbarkeit eine Viskosität von 1 mPa·s bis 10 Pa·s, insbesondere 1 mPa·s bis 100 mPa·s bestimmt nach DIN 53019 Teil 1 bis 2 und gemessen bei Zimmertemperatur auf. Entsprechende Viskositäten können durch Zugabe von Polymeren, Cellulosederivaten, oder z.B. unter der Handelsbezeichnung Aerosil erhältlichem SiO$_2$, und insbesondere durch PMMA, Polyvinylalkohol, Urethanverdicker oder Polyacrylatverdicker eingestellt werden.

Bei dem Substrat, das bei dem erfindungsgemäßen Verfahren eingesetzt wird, handelt es sich bevorzugt um ein Substrat bestehend aus Glas, Silicium, Siliciumdioxid, einem Metall- oder Übergangsmetalloxid, einem Metall oder einem polymeren Material, insbesondere PE oder PET.

Das erfindungsgemäße Verfahren ist besonders vorteilhaft ein Beschichtungsverfahren ausgewählt aus Druckverfahren (insbesondere Flexo/Gravur-Druck, Inkjet-Druck, Offset-Druck, digitalem Offset-Druck und Siebdruck), Sprühverfahren, Rotationsbeschichtungsverfahren ("Spin-coating") und Tauchverfahren ("Dip-coating"). Ganz besonders bevorzugt ist das erfindungsgemäße Druckverfahren ein Druckverfahren.

Nach der Beschichtung und vor der Konvertierung kann das beschichtete Substrat weiterhin getrocknet werden. Entsprechende Maßnahmen und Bedingungen hierfür sind dem Fachmann bekannt.

Die Konvertierung zu Indiumoxid erfolgt erfindungsgemäß durch Temperaturen von größer als 250 °C. Besonders gute Ergebnisse können jedoch erzielt werden, wenn zur Konvertierung Temperaturen von 250 °C bis 360 °C eingesetzt werden.

Dabei werden typischerweise Konvertierungszeiten von einigen Sekunden bis hin zu mehreren Stunden verwendet.

Die Konvertierung kann weiterhin dadurch unterstützt werden, dass während der thermischen Behandlung UV-, IR- oder VIS-Strahlung eingestrahlt oder das beschichtete Substrat mit Luft bzw. Sauerstoff behandelt wird. Ebenfalls ist es möglich, die nach dem Beschichtungsschritt erhaltene Schicht vor der thermischen Behandlung in Kontakt mit Wasser und/oder Wasserstoffperoxid zu bringen und diese in einem Zwischenschritt zunächst zu einem Metallhydroxid umzuwandeln, bevor die thermische Umwandlung erfolgt.

Die Güte der nach dem erfindungsgemäßen Verfahren erzeugten Schicht kann weiterhin durch eine an den Konvertierungsschritt anschließende kombinierte Temperatur- und Gasbehandlung (mit $H_2$ oder $O_2$), Plasmabehandlung (Ar-, $N_2$, $O_2$ oder $H_2$-Plasma), Laser-Behandlung (mit Wellenlängen im UV-, VIS- oder IR-Bereich) oder eine Ozon-Behandlung weiter verbessert werden.

Gegenstand der Erfindung sind weiterhin über das erfindungsgemäße Verfahren herstellbare Indiumoxid-Schichten.

Die über das erfindungsgemäße Verfahren herstellbaren Indiumoxid-Schichten eignen sich weiterhin vorteilhaft für die Herstellung elektronischer Bauteile, insbesondere die Herstellung von (Dünnschicht)Transistoren, Dioden oder Solarzellen.

Die nachfolgenden Beispiele sollen den Gegenstand der vorliegenden Erfindung näher erläutern.

**Beispiel 1**: Einfluß von Wasser

**Erfindungsgemäßes Beispiel**

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 $\mu$l einer 5 Gew.-% Lösung von Indium(III)-Isopropoxid in Isopropanol per Spin-Coating (2000 rpm) beschichtet. Um Wasser auszuschließen, wurden trockene Lösemittel (mit weniger als 200 ppm Wasser) verwendet und die Beschichtung weiterhin in einer Glove-Box (bei weniger als 10 ppm $H_2O$) durchgeführt.

Nach dem Beschichtungsvorgang wurde das beschichtete Substrat an der Luft bei einer Temperatur von 350 °C eine Stunde lang getempert.

**Vergleichsbeispiel:**

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde unter den gleichen Bedingungen wie zuvor ausgeführt mit 100 $\mu$l einer 5 Gew.-% Lösung von Indium(III)-Isopropoxid in Isopropanol per Spin-Coating (2000 rpm) beschichtet, mit dem Unterschied, dass keine getrockneten Lösemittel verwendet wurden (Wassergehalt > 1000 ppm) und die Beschichtung nicht in der Glove-Box, sondern an Luft durchgeführt wurde.

Nach dem Beschichtungsvorgang wurde das beschichtete Substrat an der Luft bei einer Temperatur von 350 °C eine Stunde lang getempert.

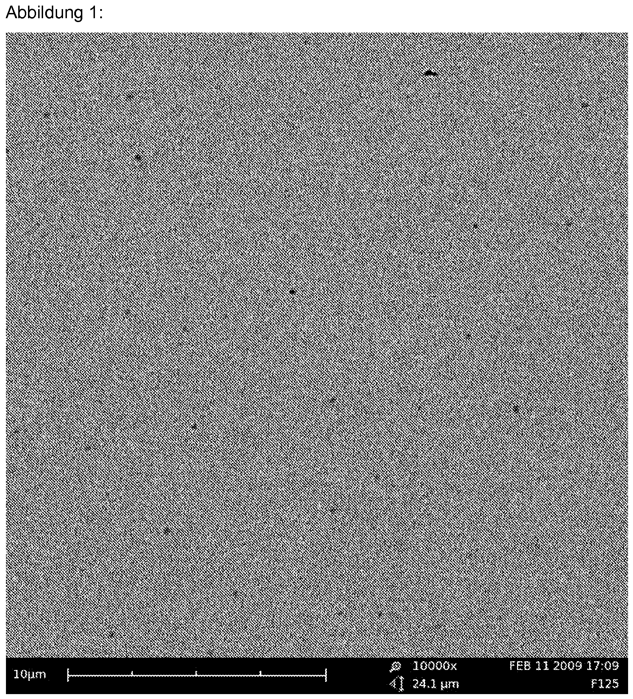

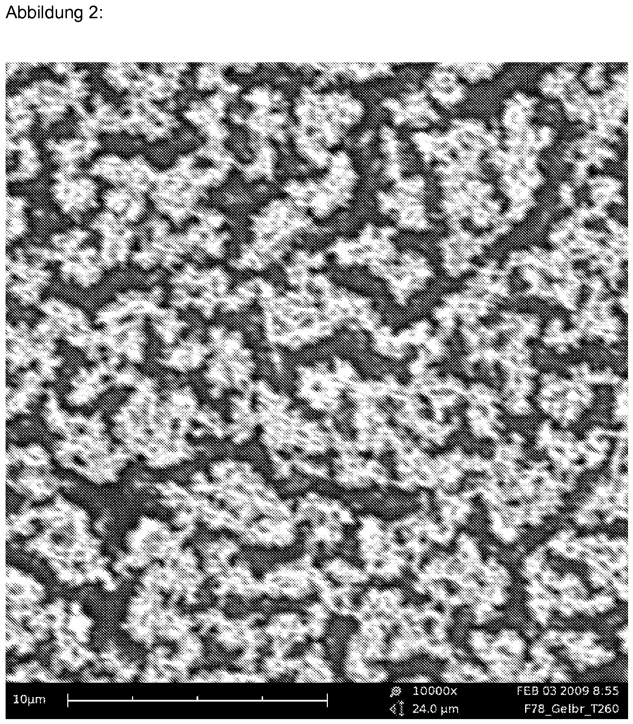

Abbildung 1 zeigt eine SEM-Aufnahme der resultierenden $In_2O_3$-Schicht der erfindungsgemäßen Beschichtung, Abbildung 2 eine entsprechende SEM-Aufnahme des Vergleichbeispiels. Deutlich zu erkennen ist die wesentlich geringere Rauhigkeit der erfindungsgemäßen Schicht. Weiterhin sind die Schichten des Vergleichsbeispiels wesentlich inhomogener als die des erfindungsgemäßen Beispiels.

Die erfindungsgemäße Beschichtung zeigt eine Ladungsträgerbeweglichkeit von 2,2 cm$^2$/Vs (bei 50 V Gate-Source-Spannung, 50 V Source-Drain-Spannung, 1 cm Kanalbreite und 20 $\mu$m Kanallänge). Demgegenüber beträgt die Ladungsträgerbeweglichkeit in der Schicht des Vergleichsbeispiels nur 0,02 cm$^2$/Vs (bei 50 V Gate-Source-Spannung, 50 V Source-Drain-Spannung, 1 cm Kanalbreite und 20 $\mu$m Kanallänge).

**Beispiel 2:** Temperatureinfluß

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde unter den gleichen Bedingungen wie in Beispiel 1 mit 100 μl einer 5 Gew.-% Lösung von Indium(III)-Isopropoxid in Isopropanol per Spin-Coating (2000 rpm) beschichtet.

Nach dem Beschichtungsvorgang wurde das beschichtete Substrat an der Luft bei verschiedenen Temperaturen über Zeiten von einer Stunde getempert. Es resultieren unterschiedliche Ladungsträgerbeweglichkeiten (gemessen bei 50 V Drain-Gate-Spannung, 50 V Source-Drain-Spannung, 1 cm Kanalbreite und 20 μm Kanallänge), die in der nachfolgenden Tabelle 1 zusammengestellt sind:

**Tabelle 1:** Ladungsträgerbeweglichkeiten

| Temperatur [°C] | Ladungsträgerbeweglichkeit [cm$^2$/Vs] |
|---|---|
| 150 | 0.06 |
| 200 | 0.065 |
| 260 | 1.20 |
| 295 | 1.1 |
| 350 | 2.2 |

Bei einem Temperierungsschritt mit Temperaturen unterhalb von 250 °C resultiert kein einsetzbarer Halbleiter. Erst durch eine Temperierung bei einer Temperatur von größer als 250 °C wird ein geeigneter Halbleiter erzeugt.

**Patentansprüche**

1. Verfahren zur Herstellung halbleitender Indiumoxid-Schichten, bei dem

   - ein Substrat
   - mit einer flüssigen, weniger als 200 ppm $H_2O$ aufweisenden Zusammensetzung umfassend

      a) mindestens ein Indium-Alkoxid und
      b) mindestens ein Lösemittel

   beschichtet, optional getrocknet, und bei Temperaturen größer 250 °C thermisch behandelt wird.

2. Verfahren nach Anspruch 1,
   **dadurch gekennzeichnet,**
   **dass** das Indium-Alkoxid ein Indium(III)-alkoxid ist.

3. Verfahren nach Anspruch 2,
   **dadurch gekennzeichnet,**
   **dass** das Indium(III)-alkoxid ein Alkoxid mit mindestens einer C1- bis C15-Alkoxy- oder -Oxyalkylalkoxygruppe, bevorzugt mindestens einer C1- bis C10-Alkoxy- oder -Oxyalkylalkoxygruppe ist.

4. Verfahren nach Anspruch 3,
   **dadurch gekennzeichnet,**
   **dass** das Indium(III)-Alkoxid ein Alkoxid der generischen Formel In(OR)$_3$, in der R eine C1- bis C15-Alkyl- oder -Alkyloxyalkylgruppe, noch weiter bevorzugt einer C1- bis C10-Alkyl- oder -Alkyloxyalkylgruppe ist.

5. Verfahren nach Anspruch 4,
   **dadurch gekennzeichnet,**
   **dass** das Indium(III)-Alkoxid In(OR)$_3$ In(OCH$_3$)$_3$, In(OCH$_2$CH$_3$)$_3$, In(OCH$_2$CH$_2$OCH$_3$)$_3$, In(OCH(CH$_3$)$_2$)$_3$ oder In(OC(CH$_3$)$_3$)$_3$, bevorzugt In(OCH(CH$_3$)$_2$)$_3$ ist.

6. Verfahren nach einem der vorhergehenden Ansprüche,
   **dadurch gekennzeichnet,**
   **dass** das Indium-Alkoxid in Anteilen von 1 bis 15 Gew.-%, besonders bevorzugt 2 bis 10 Gew.-%, ganz besonders bevorzugt 2,5 bis 7,5 Gew.-% bezogen auf die Gesamtmasse der Zusammensetzung vorliegt.

**7.** Verfahren nach einem der vorhergehenden Ansprüche,
**dadurch gekennzeichnet,**
**dass** das mindestens eine Lösemittel ein aprotisches oder schwach protisches Lösemittel ist.

**8.** Verfahren nach Anspruch 7,
**dadurch gekennzeichnet,**
**dass** das mindestens eine Lösemittel Isopropanol, Tetrahydrofurfurylalkohol, tert-Butanol oder Toluol ist.

**9.** Verfahren nach einem der vorhergehenden Ansprüche,
**dadurch gekennzeichnet,**
**dass** die Zusammensetzung eine Viskosität von 1 mPa·s bis 10 Pa·s aufweist.

**10.** Verfahren nach einem der vorhergehenden Ansprüche,
**dadurch gekennzeichnet,**
**dass** das Substrat aus Glas, Silicium, Siliciumdioxid, einem Metall- oder Übergangsmetalloxid oder einem polymeren Material besteht.

**11.** Verfahren nach einem der vorhergehenden Ansprüche,
**dadurch gekennzeichnet,**
**dass** die Beschichtung über ein Druckverfahren, Sprühverfahren, Rotationsbeschichtungsverfahren oder ein Tauchverfahren erfolgt.

**12.** Verfahren nach einem der vorhergehenden Ansprüche,
**dadurch gekennzeichnet,**
**dass** die thermische Behandlung bei Temperaturen von 250 °C bis 360 °C erfolgt.

**13.** Indiumoxid-Schicht, herstellbar nach einem Verfahren gemäß Anspruch 1 bis 12.

**14.** Verwendung mindestens einer Indiumoxid- Schicht nach Anspruch 13 zur Herstellung elektronischer Bauteile, insbesondere zur Herstellung von (Dünnschicht)Transistoren, Dioden oder Solarzellen.


**Claims**

**1.** Process for producing semiconductive indium oxide layers, in which

- a substrate is coated
- with a liquid composition containing less than 200 ppm of $H_2O$ and comprising

a) at least one indium alkoxide and
b) at least one solvent,

optionally dried and thermally treated at temperatures greater than 250°C.

**2.** Process according to Claim 1,
**characterized in that**,
the indium alkoxide is an indium(III) alkoxide.

**3.** Process according to Claim 2,
**characterized in that**,
the indium(III) alkoxide is an alkoxide with at least one C1- to C15-alkoxy or -oxyalkylalkoxy group, preferably at least one C1- to C10-alkoxy or -oxyalkylalkoxy group.

**4.** Process according to Claim 3,
**characterized in that**,
the indium(III) alkoxide is an alkoxide of the generic formula $In(OR)_3$ in which R is a C1- to C15-alkyl or -alkyloxyalkyl group, even more preferably a C1- to C10-alkyl or -alkyloxyalkyl group.

**5.** Process according to Claim 4,
**characterized in that**,
the indium (III) alkoxide is $In(OR)_3$ $In(OCH_3)_3$, $In(OCH_2CH_3)_3$, $In(OCH_2CH_2OCH_3)_3$, $In(OCH(CH_3)_2)_3$ or $In(OC(CH_3)_3)_3$, preferably $In(OCH(CH_3)_2)_3$.

**6.** Process according to any one of the preceding claims, **characterized in that** the indium alkoxide is present in proportions of 1 to 15% by weight, more preferably 2 to 10% by weight, most preferably 2.5 to 7.5% by weight, based on the total mass of the composition.

**7.** Process according to any one of the preceding claims,
**characterized in that**,
the at least one solvent is an aprotic or weakly protic solvent.

**8.** Process according to Claim 7,
**characterized in that**,
the at least one solvent is isopropanol, tetrahydrofurfuryl alcohol, tert-butanol or toluene.

**9.** Process according to any one of the preceding claims,
**characterized in that**,
the composition has a viscosity of 1 mPa·s to 10 Pa·s.

**10.** Process according to any one of the preceding claims,
**characterized in that**,
the substrate consists of glass, silicon, silicon dioxide, a metal oxide or transition metal oxide or a polymeric material.

**11.** Process according to any one of the preceding claims,
**characterized in that**,
the coating is effected by means of a printing process, spraying process, rotational coating process or a dipping process.

**12.** Process according to any one of the preceding claims,
**characterized in that**,
the thermal treatment is effected at temperatures of 250°C to 360°C.

**13.** Indium oxide layer producible by a process according to any of Claims 1 to 12.

**14.** Use of at least one indium oxide layer according to Claim 13 for producing electronic components, especially for producing (thin-film) transistors, diodes or solar cells.

**Revendications**

**1.** Procédé pour la production de couches semiconductrices d'oxyde d'indium, dans lequel

- un substrat
- est revêtu par une composition liquide, présentant moins de 200 ppm de $H_2O$, comprenant

a) au moins un alcoxyde d'indium et
b) au moins un solvant,

il est éventuellement séché et il est traité thermiquement à des températures supérieures à 250°C.

**2.** Procédé selon la revendication 1, **caractérisé en ce que** l'alcoxyde d'indium est un alcoxyde d'indium (III) .

**3.** Procédé selon la revendication 2, **caractérisé en ce que** l'alcoxyde d'indium (III) est un alcoxyde présentant au moins un groupe $C_1$-$C_{15}$-alcoxy ou $C_1$-$C_{15}$-oxyalkylalcoxy, de préférence au moins un groupe $C_1$-$C_{10}$-alcoxy ou $C_1$-$C_{10}$-oxyalkylalcoxy.

**4.** Procédé selon la revendication 3, **caractérisé en ce que** l'alcoxyde d'indium (III) est un alcoxyde de formule générique $In(OR)_3$, dans laquelle R représente un groupe $C_1$-$C_{15}$-alkyle ou $C_1$-$C_{15}$-alkyloxyalkyle, plus préférablement un groupe $C_1$-$C_{10}$-alkyle ou $C_1$-$C_{10}$-alkyloxyalkyle.

**5.** Procédé selon la revendication 4, **caractérisé en ce que** l'alcoxyde d'indium (III) est $In(OR)_3$ $In(OCH_3)_3$, $In(OCH_2CH_3)_3$, $In(OCH_2CH_2OCH_3)_3$, $In(OCH(CH_3)_2)_3$ ou $In(OC(CH_3)_3)_3$, de préférence $In(OCH(CH_3)_2)_3$.

**6.** Procédé selon l'une quelconque des revendications précédentes, **caractérisé en ce que** l'alcoxyde d'indium se trouve en des proportions de 1 à 15% en poids, de manière particulièrement préférée de 2 à 10% en poids, de manière tout particulièrement préférée de 2,5 à 7,5% en poids, par rapport à la masse totale de la composition.

**7.** Procédé selon l'une quelconque des revendications précédentes, **caractérisé en ce que** ledit au moins un solvant est un solvant aprotique ou faiblement protique.

**8.** Procédé selon la revendication 7, **caractérisé en ce que** ledit au moins un solvant est l'isopropanol, l'alcool tétrahydrofurfurylique, le tert-butanol ou le toluène.

**9.** Procédé selon l'une quelconque des revendications précédentes, **caractérisé en ce que** la composition présente une viscosité de 1 mPa.s à 10 mPa.s.

**10.** Procédé selon l'une quelconque des revendications précédentes, **caractérisé en ce que** le substrat est constitué de verre, de silicium, de dioxyde de silicium, d'un oxyde de métal ou de métal de transition ou d'un matériau polymère.

**11.** Procédé selon l'une quelconque des revendications précédentes, **caractérisé en ce que** le revêtement a lieu via un procédé d'impression, de pulvérisation, de revêtement par rotation ou d'immersion.

**12.** Procédé selon l'une quelconque des revendications précédentes, **caractérisé en ce que** le traitement thermique a lieu à des températures de 250°C à 360°C.

**13.** Couche d'oxyde d'indium, pouvant être produite par un procédé selon la revendication 1 à 12.

**14.** Utilisation d'au moins une couche d'oxyde d'indium selon la revendication 13 pour la fabrication de pièces électroniques, en particulier pour la fabrication de transistors (à couche mince), de diodes ou de cellules solaires.

Abbildung 1:

Abbildung 2:

10µm    10000x    FEB 03 2009 8.55
24.0 µm    F78_Gelbr_T260

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 11106934 A
- JP 6136162 A
- JP 9157855 A
- CN 1280960 A
- JP 11106935 A
- JP 2007042689 A

**In der Beschreibung aufgeführte Nicht-Patentliteratur**

- **H.S. KIM ; P.D. BYRNE ; A. FACCHETTI ; T.J. MARKS.** *J. Am. Chem. Soc.,* 2008, vol. 130, 12580-12581
- **H. NAKAZAWA ; Y. ITO ; E. MATSUMOTO ; K. ADACHI ; N. AOKI ; Y. OCHIAI.** *J. Appl. Phys.,* 2006, vol. 100, 093706
- **A. GUPTA ; H. CAO ; PAREKH ; K.K.V. RAO ; A.R. RAJU ; U.V. WAGHMARE.** *J. Appl. Phys.,* 2007, vol. 101, 09N513
- **S. CHATTERJEE ; S. R. BINDAL ; R.C. MEHRO-TRA.** *J. Indian Chem. Soc.,* 1976, vol. 53, 867
- **D.C. BRADLEY ; H. CHUDZYNSKA ; D.M. FRIGO ; M.E. HAMMOND ; M.B. HURSTHOUSE ; M.A. MAZID.** *Polyhedron,* 1990, vol. 9, 719
- **S. SUH ; D. M. HOFFMAN.** *J. Am. Chem. Soc.,* 2000, vol. 122, 9396-9404